(19) Europäisches Patentamt / European Patent Office / Office européen des brevets

(11) **EP 4 009 065 A1**

(12) # EUROPEAN PATENT APPLICATION
published in accordance with Art. 153(4) EPC

(43) Date of publication:
**08.06.2022 Bulletin 2022/23**

(21) Application number: **20849459.1**

(22) Date of filing: **24.07.2020**

(51) International Patent Classification (IPC):
*G01R 33/38* (2006.01)    *G01R 33/48* (2006.01)

(86) International application number:
**PCT/ES2020/070481**

(87) International publication number:
**WO 2021/023902 (11.02.2021 Gazette 2021/06)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **02.08.2019 ES 201930719**

(71) Applicants:
• **CONSEJO SUPERIOR DE INVESTIGACIONES CIENTÍFICAS (CSIC)**
  **28006 Madrid (ES)**
• **UNIVERSITAT POLITÈCNICA DE VALÈNCIA**
  **46022 Valencia (ES)**

(72) Inventors:
• **BENLLOCH BAVIERA, José María**
  **Camino de Vera S/N Edificio 8B, Acceso K, 2a Planta. Sala 004**
  **46022 Valencia (ES)**
• **GALVE CONDE, Fernando**
  **Camino de Vera S/N Edificio 8B, Acceso K, 2a Planta. Sala 004**
  **46022 Valencia (ES)**
• **ALONSO OTAMENDI, Joseba**
  **Camino de Vera S/N Edificio 8B, Acceso K, 2a Planta. Sala 004**
  **46022 Valencia (ES)**
• **ALGARÍN GUISADO, José Miguel**
  **Camino de Vera S/N Edificio 8B, Acceso K, 2a Planta. Sala 004**
  **46022 Valencia (ES)**

(74) Representative: **Tribalyte Ideas**
  **Gta. Quevedo 8, 6°2**
  **28015 Madrid (ES)**

(54) **METHOD AND APPARATUS FOR ACQUIRING IMAGES OF AN OBJECT BY MEANS OF MAGNETIC RESONANCE, USING TIME-VARIABLE INHOMOGENEOUS MAGNETIC FIELDS**

(57) The present invention relates to a method and to an apparatus for acquiring images of an object by magnetic resonance through the use of time-varying inhomogeneous magnetic fields, configured for: a) generating a plurality of time-varying, inhomogeneous, gradient-type magnetic fields on a region of interest, producing a spatial encoding of the magnetization of the nuclear spins of said object; b) applying a plurality of radiofrequency radiation pulse sequences, generating magnetic resonance signals; c) detecting, demodulating, and storing the generated magnetic resonance signals, completing a first magnetic resonance scan; d) repeating steps a)-c), carrying out one or more improvement scans; and e) reconstructing the spectra of the magnetic resonance signals emitted by the nuclei of the object and one or more images thereof.

FIG. 2

**Description**

**FIELD OF THE INVENTION**

The present invention relates, in general, to the field of magnetic resonance imaging (MRI "Magnetic Resonance Imaging") techniques, and in particular, to the reconstruction of three-dimensional (3D) images based on a single acquisition of a magnetic resonance (MR) signal for an entire volumetric sample.

**BACKGROUND OF THE INVENTION**

Since it was invented at the beginning of the 1970s, nuclear magnetic resonance (NMR) based technologies have had an enormous impact, especially in the health sector, where they surpass any other method available for soft tissue imaging. This is primarily due to the fact that MR is the only known technique capable of *in vivo* deep tissue imaging with high spatial resolution and of simultaneously avoiding the use of harmful ionizing radiations on said tissues.

The most widely recognized limitation with respect to current MRI techniques are the long scanning times needed for imaging. In this sense, advancements have been made in recent years in the development of techniques based on magnetic pulse sequences referred to as "ultrafast sequences", which are used at present with varying degrees of success. The potential applications of said ultrafast sequences allow real-time dynamic imaging, myocardial perfusion imaging, high-resolution coronary imaging, functional neuroimaging, diffusion imaging, or whole-body scanning.

In general, MRI protocols are based on the execution of a magnetic pulse sequence, formed by an initial resonant excitation of nuclear spins contained in a region of interest (ROI), followed by a series of magnetic pulses which determine the response of said spins and encode the spatial information thereof in the ROI. In this series of pulses, the inhomogeneous magnetic fields provide a Larmor or rotation precession frequency that depends on the position of the nuclei in the ROI, which can be expressed mathematically as:

$$\omega_{\mathrm{L}}(\vec{r}, t) = \gamma \left| \vec{B}(\vec{r}, t) \right| ,$$

(Eq. 1)

wherein y is the gyromagnetic ratio ($\approx 2\pi \cdot 42$ MHz/T for protons) and **B** is the magnetic field at position rand at instant t in time. As the pulse sequence evolves, the MR phase $\Phi(r,t)$ acquired by the spins depends on the position in which they are found, which provides a spatial encoding over time that is used for imaging:

$$\Phi(\vec{r}, t) = \int_0^t \omega_{\mathrm{L}}(\vec{r}, t')\mathrm{d}t' = \int_0^t \gamma |\vec{B}(\vec{r}, t')|\mathrm{d}t' .$$

(Eq. 2)

During their precession, the spins induce a signal which varies over time with the interference of all the spins in a detector close to the ROI:

$$s(t) = f(\vec{r}, \omega) \int_{\mathrm{RoI}} \mathrm{e}^{-\mathrm{i}\Phi(\vec{r},t)} \rho(\vec{r})\mathrm{d}\vec{r} ,$$

(Eq. 3)

wherein *p(r)* is the spin density distribution in the ROI and *f(r,ω)* represents the frequency response of said detector, as well as its position-dependent sensitivity. The mentioned signal is digitized during a reading or data acquisition interval and mathematically treated to reconstruct the corresponding image.

MR-based scanners typically use fields having a linear gradient, where inhomogeneous higher-order terms are not taken into account. In the presence of a linear gradient along a spatial direction, the Larmor frequency varies in a linear manner with the position, and the time-dependent signal s(t) is a coherent summation of sinusoidal components, weighted by the number of spins in each voxel (or 3D pixel). In Fourier space, also known as "spatial frequency" or "k-space", this corresponds to a set of area peaks, proportional to the number of spins with a given Larmor frequency (i.e., at a given position). As the time during which the sample is subjected to the linear magnetic gradient increases, the corresponding values in k-space grow proportionally, which provides information about smaller spatial characteristics, and, therefore, the spatial resolution of the reconstructed image increases.

In this scenario, a Fourier transform (FT) of *s(t)* is sufficient to reconstruct p(r). This is due to the fact that under the mentioned conditions, the integral in Eq. 2 is trivial and Eq. 3 is simplified as follows:

$$s(t) = \int e^{-i\gamma G_z z t} \rho(z)\mathrm{d}z$$
(Eq. 4)

wherein it is assumed, without loss of generality, that a gradient of force $G_z$ points along the z-axis. Therefore, $\gamma G_z \cdot t$ can be considered a spatial frequency k, and $\rho(z)$ can be reconstructed by performing inverse FT on $s(t)$.

To produce 2D and 3D images, gradient fields (also referred to in simplified form as "gradients") are activated and deactivated in different directions and at different instants, as part of the MR pulse sequence. MR scanners are typically designed to produce linear gradients on a field of view (FOV), and pulse sequences are designed to perform sampling of a plane or of a volume in k-space, after which Fourier analysis can be used in a simple manner to reconstruct said plane or volume in real space.

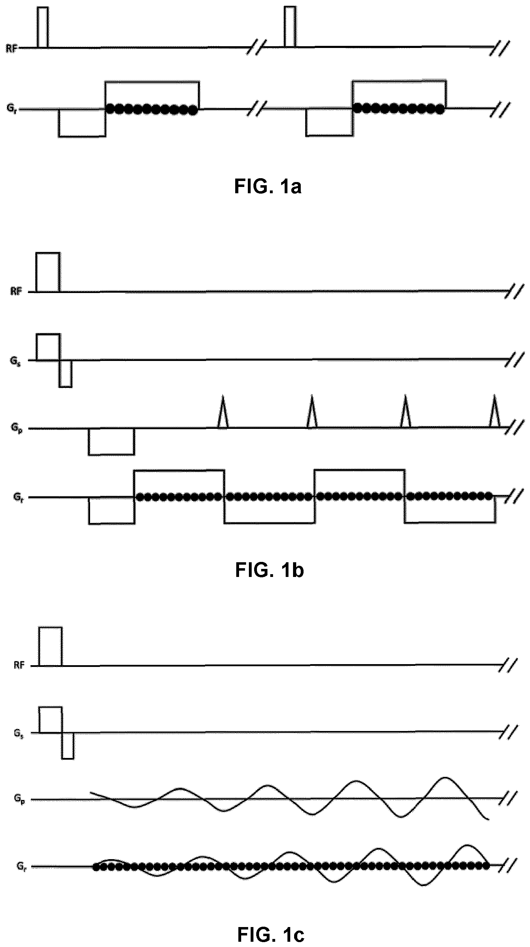

The sequence of Figure 1a is a known Gradient-Echo (GRE) sequence, which is a simplified embodiment of the described formalism. In GRE, after the initial resonant excitation, a linear gradient $G_r$ along a given reading direction is pulsed for the duration of a certain time, which causes the effective k variable to acquire a finite value. After that, the polarity of the gradient changes and the amplitude and duration thereof are designed to cross k = 0 after a certain time, whereby cancelling the phases of all the spins and producing a high-amplitude echo in the induced signal s(t).

The sequence in Figure 1b is a known Echo-Planar Imaging (EPI) sequence, which is an extension of the GRE technique to a 2D plane. In this case, the small peaks or blips in $G_p$ along the "phase" direction change the line sampled with each echo, so the sequence sweeps a two-dimensional k-space, which allows producing a 2D image. This sequence can be trivially extended to three spatial dimensions, exciting a thick section or a whole volume and performing phase encoding (or "blipping") of the gradient of said section or volume, every time a plane in k-space has been scanned over. Examples of this type of sequences are techniques known as "Echo-Volumar Imaging" (EVI) or "3D EPI".

In general, objects in d dimensions can be reconstructed by means of a simple Fourier analysis for any MR sequence filling in a d-dimensional k-space. This means that the k-space concept is the cornerstone of current magnetic resonance. As a consequence, most MRI pulse sequences are designed to sweep the whole k-space in different ways and, therefore, to collect information required to produce FT-based images.

The spiral MR sequence (Figure 1c) is another example of what has been discussed above. In this pulse technique, the gradients along the phase and reading directions are caused to oscillate with a phase difference $\pi/2$ and with an amplitude that increases over time. This leads to a trajectory spiraling outwardly from the origin, sweeping the k-space in 2D and, therefore, allowing 2D image reconstructions.

To obtain 2D images, the strategies conceived for achieving high-speed results are primarily based on increasing the MR pulse sequence work cycle. With conventional sequences, such as GRE, for example, a single echo is induced and read in each sequence repetition. The echo time is typically on a millisecond time scale, while repetition times are much slower. Given that echoes are the part of the induced signal where useful information is concentrated, the effective work cycle of these sequences is very low. This limitation is greatly improved in ultrafast sequences (for example, with EPI), where multiple echoes are concatenated in a single repetition, or in spiral MR, which are based on curved trajectories in k-space. This means that the imaging of a single spatial section (i.e., in 2D) can be largely accelerated with improvement factors in the order of 100.

In turn, obtaining high-resolution three-dimensional reconstructions is slow. In reference to this limitation, an example scenario in which a 3D object is sampled with 32 planar slices and 32 lines per slice can be considered. With EPI, an echo provides a line in a portion, so if said echo presents a propagation time of 1 ms, a single portion would require 32 ms, and the whole volume would require around 1 s. Furthermore, this time would be much slower with other techniques such as GRE, due to the reduced work cycle with respect to EPI.

The EVI (or 3D EPI) sequences mentioned above can mitigate the problem with long scanning times compared with those of other sequences. In these sequences, a volume or thick section is divided into slices, and two spatial dimensions are phase-encoded, which provides a better Signal-to-Noise ratio (SNR) than an EPI sequence, for example. Likewise, the reading direction is frequency-encoded the same way as in EPI. Nevertheless, EVI poses enormous requirements on the hardware side, which results in very long pulse trains, a low voxel bandwidth, high sensitivity to inhomogeneities of the magnetic field, intense acoustic noise, and a highly anisotropic spatial resolution.

3D sample reconstruction with a high isotropic resolution therefore represents a challenge in the field of MRI, due to the nature of the sequences used. One way to mitigate this problem is to use "super-resolution" (SR) techniques, which combine several low-resolution images, forming a high-resolution image high-resolution. This approach allows for improved resolution across the plane (along the direction of selecting the scanned spatial section), but there is a dispute today within the scientific community with respect to its volumetric performance (that is, within the selected section).

In light of the limitations of the state of the art discussed above, the development of new MRI methods, which allow surpassing known techniques for 2D or 3D imaging with high spatial resolution, which furthermore allow working with low response times, is necessary in the present technical field. The present invention proposes a solution to said need by means of a novel method based on the use of time-varying, inhomogeneous magnetic fields and an apparatus comprising the means for performing said method.

BRIEF DESCRIPTION OF THE INVENTION

The present invention approaches the problems mentioned above and provides a method and an apparatus for uniquely encoding the spatial information of a volumetric sample and reconstructing three-dimensional objects with tools that retrieve information that is inaccessible for conventional spectral analysis, as it does not require travelling in k-space.

In the method of the invention, a radiofrequency (RF) pulse excites the spin nuclei in a resonant or quasi-resonant manner and rotates the net magnetization of a ROI. Said nuclei may correspond to the whole 3D field of view of the scanner or a volumetric part thereof, and the invention may also be applied to cases of one or two spatial dimensions. Time-varying, inhomogeneous magnetic fields are subsequently applied along different directions in space to induce a unique MR phase evolution for each point in the ROI. Like in conventional MR, an experimental control system reads the interference signal of the excited nuclei, induced in one or more nearby detectors. Prior knowledge of the temporal and spatial characteristics of the inhomogeneous fields generated can be used to reconstruct spin distribution in the ROI. These characteristics can be determined from design parameters and from simulations, or from experimental calibration executions, as is typically done in conventional MRI experiments to determine scanner gradient linearity.

In the method of the invention, the interpretation of data and the reconstruction of the image is based on the use of analysis tools going beyond the Fourier transforms used in the known techniques, as well as the spectral analysis and extensions of said transforms, which allow reconstructions of images of the objects even when the k-space is not swept and in the presence of non-linear inhomogeneities of the magnetic field, therefore causing said k-space to be unnecessary for imaging.

As mentioned, the described method is based on time-varying, inhomogeneous magnetic fields, pulsed during reading or acquisition intervals, such that the MR phase evolution is unique for each point of the ROI, and wherein the projection of the local gradient field, along each of the three orthogonal spatial axes in the laboratory frame of reference does not fade away for at least a fraction of the duration of the pulse at each point of the ROI. For applying super-resolution techniques with the method of the invention, this sequence can be repeated one or more times with a small variation of the parameters of the sequence, of the analog/digital processing of the data, or of both.

As described in earlier paragraphs, a first object of the invention therefore relates to a method for acquiring images of an object by magnetic resonance through the use of time-varying inhomogeneous magnetic fields, wherein in an advantageous manner, said method preferably comprises performing the following steps:

a) generating a plurality of time-varying, inhomogeneous, gradient-type magnetic fields on a region of interest in which the object is completely or partially contained, producing a spatial encoding of the magnetization of the nuclear spins of said object in the region of interest;

b) applying a plurality of radiofrequency electromagnetic radiation pulse sequences on the object, generating magnetic resonance signals, wherein:

- the spins of the object in the region of interest are resonantly excited with the radiofrequency electromagnetic radiation pulses;
- the inhomogeneous magnetic fields are pulsed for one or more signal acquisition intervals, such that the evolution of the magnetic resonance phase of the spins is unique for each point of said region of interest; and
- the projection of local gradient magnetic fields along each of the three orthogonal spatial axes in the laboratory frame of reference does not fade away for at least a fraction of the duration of the radiofrequency pulses in the region of interest;

c) detecting, demodulating, and storing the generated magnetic resonance signals, completing a first magnetic resonance scan of the object;

d) repeating steps a)-c) above, carrying out one or more improvement scans, providing separate information about the object in said scans;

e) reconstructing the spectra of the magnetic resonance signals emitted by the nuclei of the object and one or more images of said object from the information generated by means of steps a)-d) and from the temporal and spatial characteristics of the inhomogeneous magnetic fields generated in the region of interest for each scan.

As a result of these features, the method of the invention allows the limitations of the state of the art described in the preceding section to be overcome as a result of a spatial encoding and reconstruction method for the fast generation of volumetric MR which allows super-resolution and provides, among others, the following advantages:

- Volumetric excitations of spin.
- High Signal-to-Noise ratio.
- Single-shot sequences.
- Smooth variation of the magnetic fields instead of long pulse trains.
- Possibility of being configured for isotropic or anisotropic spatial resolution.
- Allowing super-resolution techniques in all spatial dimensions.
- Increased voxel bandwidth.
- Less acoustic noise.
- Absence of phase-encoded directions.

Likewise, in a preferred embodiment of the invention the method comprises, in each of the improvement scans of step d):

- the pulse sequence of the inhomogeneous magnetic field gradients is carried out with modifications in the spatial distribution, the magnitude, or the temporal evolution of said magnetic fields, in relation to the first scan or to one another; and/or
- the processing of magnetic resonance signals being performed by means of an analytical reconstruction method differing from the reconstruction method of the first scan.

In another preferred embodiment of the invention, the generation of inhomogeneous magnetic fields comprises a linear or non-linear magnetic field gradient which rotates or oscillates about an axis in a plane, and a second static, linear or non-linear magnetic field gradient, applied along a normal axis to said plane.

In another preferred embodiment of the invention, the generation of inhomogeneous magnetic fields comprises a first linear or non-linear magnetic field gradient which rotates about an axis in a plane, and a second linear or non-linear magnetic field gradient which oscillates along the normal axis to said plane, and at a different angular frequency with respect to that of the first gradient.

In another preferred embodiment of the invention, the generation of inhomogeneous magnetic fields comprises a plurality of linear or non-linear magnetic field gradients, which are made to oscillate and/or rotate over time along the three orthogonal axes in space.

In another preferred embodiment of the invention, the angular frequency and/or the phase of the magnetic field gradients rotating and/or oscillating vary in each improvement scan in step d).

In another preferred embodiment of the invention, one or more of the inhomogeneous magnetic field gradients are zero in a value of space or of time, and wherein said gradients shift and/or evolve differently in each improvement scan in step d).

In another preferred embodiment of the invention, the magnetic resonance signals are demodulated with a different frequency in each improvement scan in step d).

In another preferred embodiment of the invention, the detection of step c) is performed by means of an array-type arrangement of receiving coils, and by means of applying parallel magnetic resonance image reconstruction techniques.

In another preferred embodiment of the invention, the reconstruction of the images of step e) is carried out by means of the inversion of an encoding matrix, and said matrix is multiplied by the vector of the recorded discrete time signal, or with its discrete Fourier transform.

In another preferred embodiment of the invention, image reconstruction is carried out by means of an analytical method for the iterative resolution of a system of linear equations, which relates the recorded magnetic resonance signal with the spin density distribution of the object.

In another preferred embodiment of the invention, image reconstruction is performed by means of using Hankel transforms or by means of integrating Bessel functions, with or without the use of an encoding matrix.

In another preferred embodiment of the invention, the temporal evolution of the magnetic resonance phase of the spins of the object is inverted by means of the dynamic control of magnetic field gradients, generating one or more echoes in the detected magnetic resonance signal.

In another preferred embodiment of the invention, inhomogeneous field gradients vary only in two spatial dimensions, and the reconstructed image is a 2D image.

A second object of the invention likewise relates to an apparatus for acquiring images of an object by magnetic resonance through the use of time-varying inhomogeneous magnetic fields, comprising:

- a magnet casing;
- a main magnet housed in the casing and suitable for generating a magnetic field on the object;
- a plurality of compensation coils;
- a plurality of gradient coils suitable for generating a plurality of inhomogeneous magnetic field gradients on a region of interest in which the object is completely or partially arranged;
- one or more radiofrequency coils suitable for generating radiofrequency electromagnetic radiation pulses on the object;
- one or more receiving coils;
- a control system for controlling the magnetic field generated by the main magnet, of the field generated by the gradient coils, and for controlling the pulses generated by the radiofrequency coils, configured for generating magnetic resonance signals in the object; and
- a system for detecting, demodulating, and storing the generated magnetic resonance signals.

Advantageously, the control system for controlling the magnetic field and the system for detecting, demodulating, and storing the generated magnetic resonance signals are configured, through hardware and software-based processing means, for carrying out a method according to any of the preceding claims.

The above and other aspects and advantages of the present invention will become apparent from the following detailed description and of the attached drawings, in which different preferred embodiments of the invention are shown by way of example. However, said embodiments do not necessarily represent the full scope of the invention and are understood as being non-limiting of the full scope of the invention.

DESCRIPTION OF THE DRAWINGS

Figures 1a-1c show a comparison between GRE, EPI, and spiral pulse sequences, respectively, according to known embodiments in the state of the art, where the RF excitation pulse and the temporal evolution of an inhomogeneous oscillating magnetic field ($G_s$, $G_p$, $G_r$) along three directions orthogonal in space are represented.

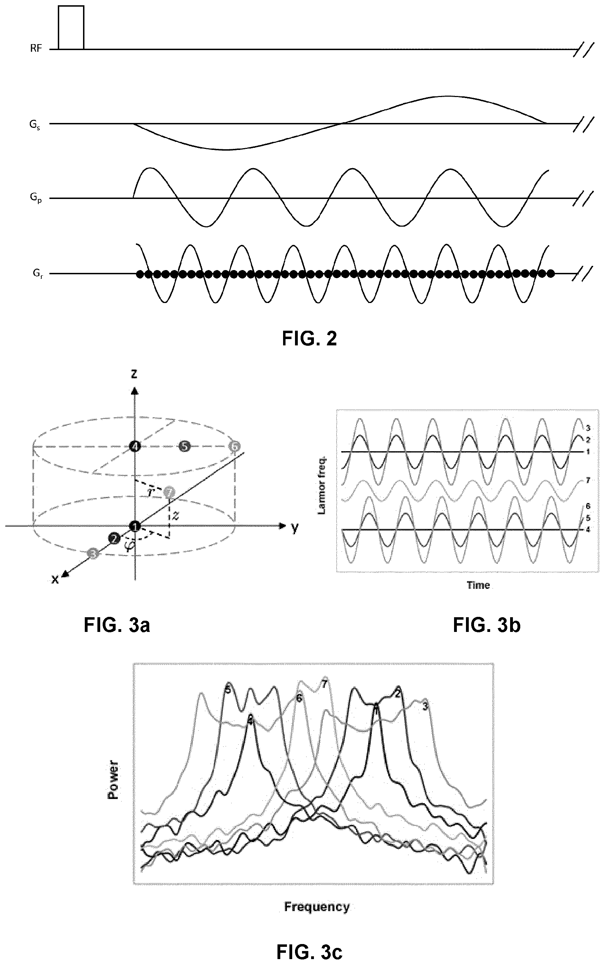

Figure 2 shows a diagram with a pulse sequence according to the present invention, where the RF excitation pulse and the temporal evolution of an inhomogeneous oscillating magnetic field ($G_s$, $G_p$, $G_r$) along three directions orthogonal in space are represented.

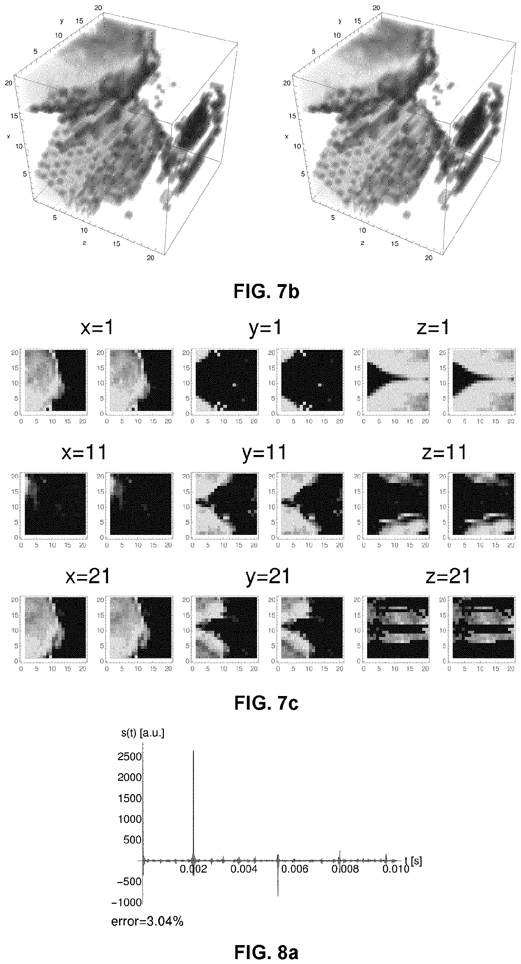

Figures 3a-3c illustrate the unique phase evolution of the MR signal for each position in a scanner implementing the method of the invention. Figure 3a shows seven selected points from the ROI. Figure 7b represents the Larmor (rotation precession) frequency over time for each of the seven points during a plurality of rotation periods of the field. Figure 7c represents the power spectra of the MR signals emitted by the nuclei, in the specified locations in the ROI.

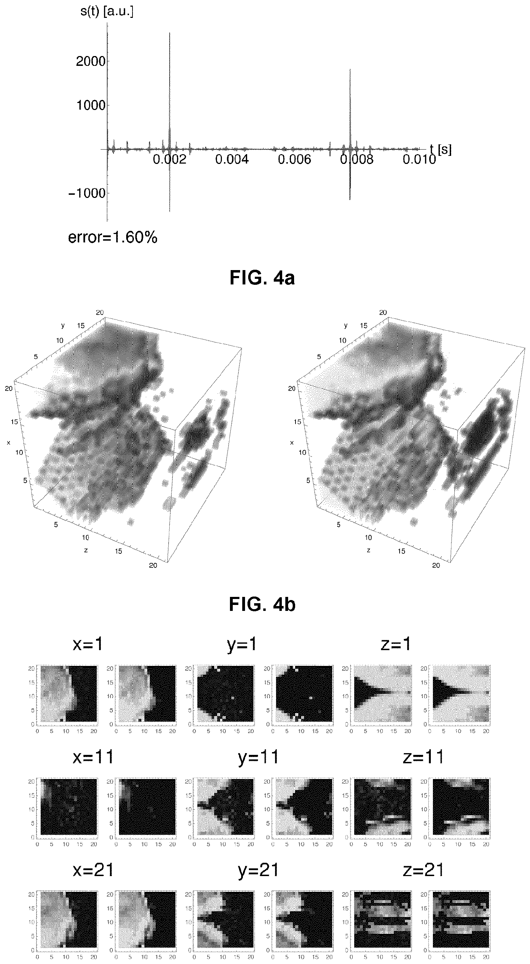

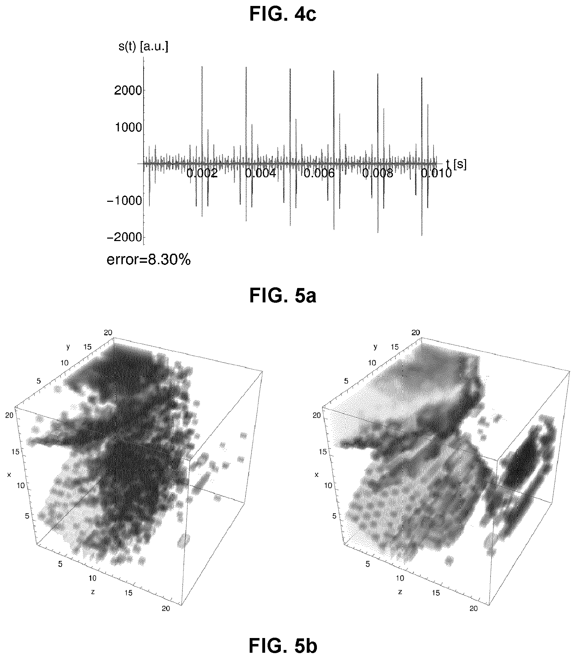

Figure 4 shows a computer simulation of a pulse sequence according to the invention, with an oscillating linear gradient at ≈173 Hz in the xy-plane, and with a static gradient along the z-axis. In this example, a linear gradient of 0.3 T/m rotates about the z-axis at an angle of 45° at an angular frequency $\omega_R \approx 2\pi \cdot 173$ Hz. Figure 4a shows the real components (blue) and imaginary components (orange) of the detected MR signal. Figures 4b and 4c represent the comparison between the reconstructed object and the original object, respectively. Figure 4d represents the same comparison, with a selection of cross sections in directions x, y, z.

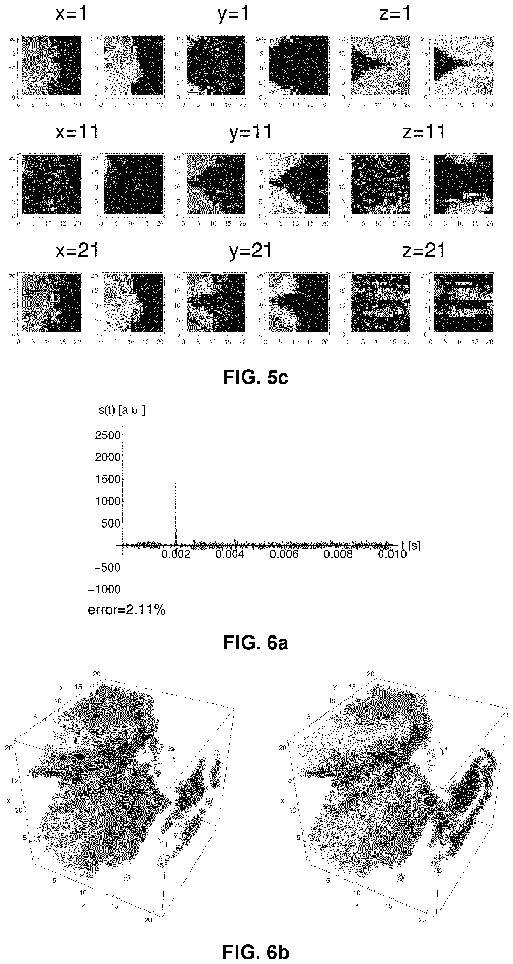

Figure 5 shows a computer simulation of a pulse sequence according to the invention, with an oscillating linear gradient at ≈10 kHz in the xy-plane, and with a static gradient along the z-axis. In this example, a linear gradient of 0.3 T/m rotates about the z-axis at an angle of 45° at an angular frequency $\omega_R \approx 2\pi \cdot 10$ kHz. Figure 5a shows the real components (blue) and imaginary components (orange) of the detected MR signal. Figures 5b and 5c represent the comparison between the reconstructed object and the original object, respectively. Figure 5d represents the same comparison, with a selection of cross sections in directions x, y, z.

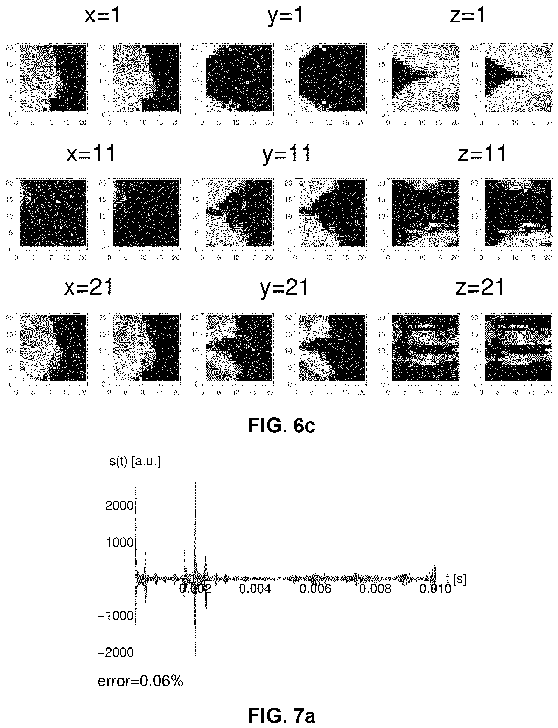

Figure 6 shows a computer simulation of a pulse sequence according to the invention, with an oscillating non-linear gradient at ≈173 Hz in the xy-plane, and with a static non-linear gradient along the z-axis. In this example, an inhomogeneous non-linear field of 0.3 T/m in all directions, as well as second-order terms of sizes in the axial and radial directions having values of 16.3 and -4.7 T/m$^2$, respectively, rotate about the z-axis at an angle of 45 degrees at an angular frequency $\omega_R \approx 2\pi \cdot 173$ Hz. Figure 6a shows the real components (blue) and imaginary components (orange) of the detected MR signal. Figures 6b and 6c represent the comparison between the reconstructed object and the original object, respectively. Figure 6d represents the same comparison, with a selection of cross sections in directions x, y, z.

Figure 7 shows a computer simulation of a pulse sequence according to the invention, with an oscillating linear gradient at ≈10 kHz in the xy-plane, and with a static gradient along the z-axis. In this example, an inhomogeneous non-linear field of -0.7 T/m in all directions, as well as second-order terms have sizes in the axial and radial directions having values of 16.3 and -4.7 T/m², respectively, rotate about the z-axis at an angle of 45 degrees at an angular frequency $\omega_R \approx 2\pi \cdot 100$ kHz. Figure 7a shows the real components (blue) and imaginary components (orange) of the detected MR signal. Figures 7b and 7c represent the comparison between the reconstructed object and the original object, respectively. Figure 7d represents the same comparison, with a selection of cross sections in directions x, y, z.

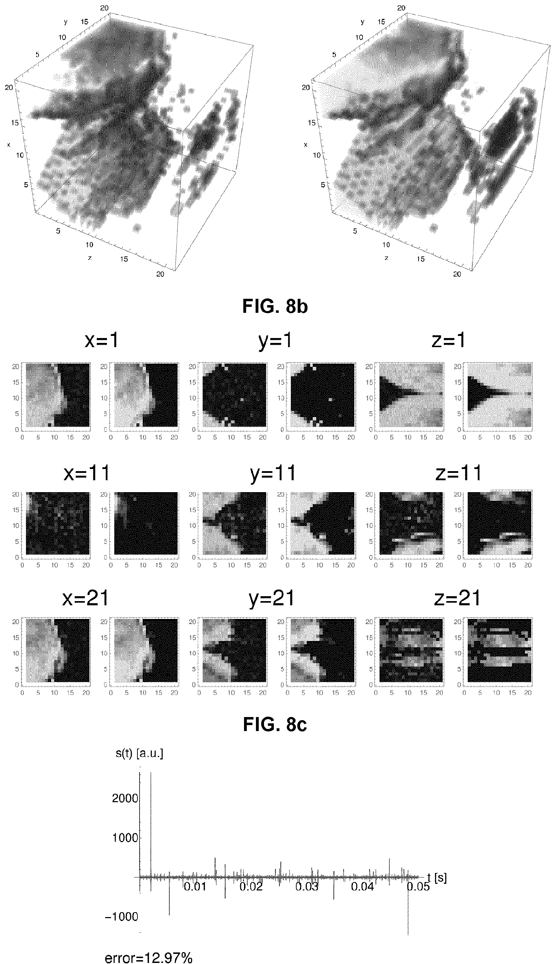

Figure 8 is a computer simulation of a pulse sequence according to the invention, (10 ms) with an oscillating linear gradient in the xy-plane, an oscillating linear gradient along the z-axis, and reconstruction based on direct matrix inversion. In this example, a linear gradient of 0.3 T/m rotates in the xy-plane at an angular frequency $\omega_R \approx 2\pi \cdot 173$ Hz and a linear gradient of 0.3 T/m oscillates along the z-axis at $\omega_{ax} = 2\pi \cdot 100$ Hz. Figure 8a shows the real components (blue) and imaginary components (orange) of the detected MR signal. Figures 8b and 8c represent the comparison between the reconstructed object and the original object, respectively. Figure 8d represents the same comparison, with a selection of cross sections in directions x, y, z.

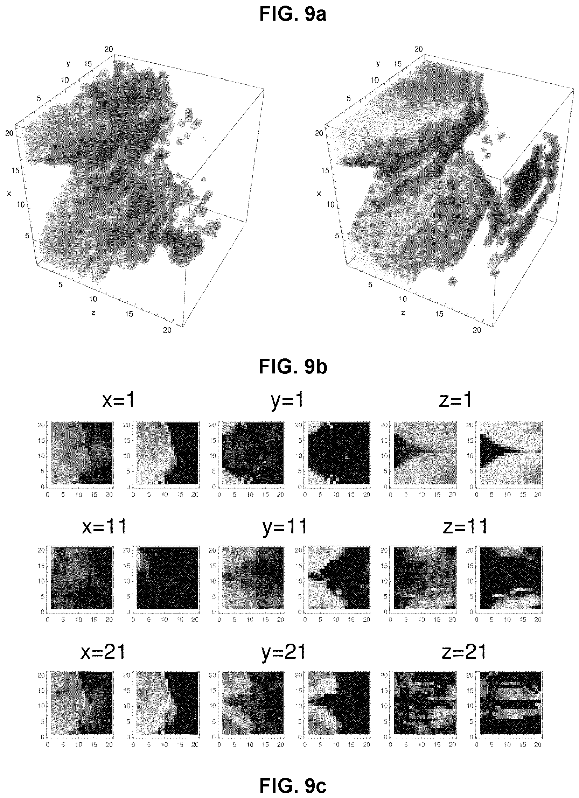

Figure 9 is a computer simulation of a pulse sequence according to the invention, (50 ms) with an oscillating linear gradient in the xy-plane, an oscillating linear gradient along the z-axis, and reconstruction based on algebraic reconstruction techniques. In this example, a linear gradient of 0.3 T/m rotates in the xy-plane at an angular frequency $\omega_R \approx 2\pi \cdot 173$ Hz and a linear gradient of 0.3 T/m oscillates along the z-axis at $\omega_{ax} = 2\pi \cdot 100$ Hz. Figure 9a shows the real components (blue) and imaginary components (orange) of the detected MR signal. Figures 9b and 9c represent the comparison between the reconstructed object and the original object, respectively. Figure 9d represents the same comparison, with a selection of cross sections in directions x, y, z.

## DETAILED DESCRIPTION OF THE INVENTION

A detailed description of the invention in reference to different preferred embodiments thereof, based on Figures 2-9 of the present document, is set forth below. Said description is provided for illustrative but non-limiting purposes of the claimed invention.

The key concept serving as the basis of the method of the invention is schematically shown in Figure 2 and as described above, allows the volumetric encoding of images without resorting to analysis in k-space. According to said method, the inhomogeneities of the time-varying magnetic field ($G_s$, $G_p$, $G_r$) produce, in a general manner, a unique MR phase encoding for each position in the ROI, which allows the reconstruction of 3D objects even when the k-space is not filled and, therefore, Fourier transforms are no longer a useful tool for image reconstruction.

Described below are the details of the method of the invention for performing MRI, wherein the inhomogeneous magnetic field that spatially encodes the sample of the image varies over time and is not necessarily linear in space. An essential part of this method is the analytical reconstruction, preferably based on the resolution of a system of linear equations which relates the MR signal recorded in the detectors with the spin density distribution through an encoding matrix (EM) including all the prior knowledge about the temporal and spatial characteristics of the inhomogeneous magnetic field in the whole pulse sequence.

In conventional MR techniques, spatial information comes from a single source (nuclei at different positions, which precess with different frequencies). Nevertheless, this particularity is not applied in the method of the invention, wherein the inhomogeneous magnetic fields are not necessarily linear and furthermore vary over time. For example, in a configuration according to the invention with a rotating linear gradient in the xy-plane, superimposed on a static linear gradient along z (leading to a helical trajectory in k-space), there are three independent sources of spatial information (see Figure 3, by way of example):

- The position-dependent precession frequency: there is a linear gradient along the z-axis.
- The position-dependent frequency modulation depth: the MR signal emitted by the spins is frequency-modulated, with a depth proportional to the radial coordinate r (distance from the z-axis).
- The position-dependent frequency modulation phase: the MR signal emitted by the spins is frequency-modulated, with a phase proportional to the angular coordinate $\phi$ (angle around the z-axis).

Once the time-dependent signal (resulting from the interference of the precessing nuclei) has been recorded and discretized, s(t) becomes a vector **S** having a length equal to the number of time steps $t_n$; p(r) becomes a vector $\rho$ having a length equal to the amount of voxels $v_n$, and $\Phi(r,t)$ becomes the modification matrix with $t_n$ rows and $v_n$ columns. After discretization, Equation 3 described above becomes:

$$\mathbf{S} = \mathbf{\Phi}\rho ,$$

(Eq. 5)

and $\rho$ can be obtained by direct inversion of the Encoding matrix as $\Phi^{-1}\cdot\mathbf{S}$, or by any other means for solving the system of linear equations, for example, by means of iterative algorithms such as algebraic reconstruction techniques (ART).

Spatial resolution is not a trivial concept in the method of the invention. In standard MR, the spatial resolution is determined by the distance between the points the accumulated phase of which differs by a certain amount after a specific acquisition time. Since the gradients are linear and static, the only relevant parameter is the projection of the line between the points in the direction of the gradient. Isophase surfaces are, therefore, planes that are perpendicular to the gradient, and two points cannot be resolved if they are located in the same plane. This is not the case of the method of the invention, where each point evolves following a unique trajectory (see Figure 3).

An essential factor in this sense is that the phase differences between MR signals are not, strictly speaking, what define the capacity to resolve two points in space. Using an excessive simplification, it is normally assumed in conventional MRI that $\delta\varphi = \gamma G_z \cdot \delta z \cdot t_{acq}$, with y being the gyromagnetic factor, $G_z$ the intensity of the gradient of the magnetic field, $t_{acq}$ the acquisition time, and $\delta z$ the spatial resolution along z. However, it is not the instantaneous phase difference that matters (the phase rotates at 0 and $2\pi$), but rather the full phase trajectory for each voxel. Spatial resolution in the most general scenario of the method of the invention presents anisotropies depending in a non-trivial manner on parameters such as the total acquisition time, the temporal dependence of the magnetic field inhomogeneities, or the spatial distribution thereof. Accordingly, there is a wide range of situations in which spatial resolution and the anisotropy thereof can be designed. This flexibility contrasts remarkably with respect to other known volumetric sequences, such as EVI, where the resolution of anisotropy is an important limitation, and this is due to the fact that in the method of the invention, inhomogeneous magnetic fields may vary throughout the three dimensions, and there is no need for phase encoding along any spatial direction.

In connection with the possibility of super-resolution in the method of the invention, serving as the general basis is the fact that the greater the dimensionality of the reconstructed sample, the lower the resolution obtained. In this context and in a preferred embodiment of the invention, known super-resolution (SR) techniques can be used in the present method to improve reconstructions by increasing the number of low-resolution scans.

Moreover and in another preferred embodiment, the method of the invention allows performing repeated "improvement" scans, which provides complementary spatial information that can be combined to generate a high-resolution reconstruction. This concept, which also originates from SR techniques, can be implemented in several ways. For example, for a particular case in which an inhomogeneous magnetic field rotates about an axis in a plane, and a static linear gradient magnetic field is applied along said axis, different scans can be performed at different rotation frequencies, imprinting different sides bands in the spectrum of the detected MR signal. Another more general possibility is to repeat the scan several times with identical parameters, demodulating the MR signal into slightly different frequencies each time, similar to the above-mentioned SR techniques SR in the plane.

With respect to tissue contrast in the method of the invention, echoes are constructive interference effects having a large amplitude that are produced when all the spins are rephased, and they contain most of the useful information about the acquired signal since the effects of harmful noise are mitigated during said echoes. In order to produce an echo, pulse sequences are designed to invert the evolution over time of the system at exactly the middle of the echo time, $T_E$. This can be achieved by inverting the MR sequence, such that during $T_E/2 \leq t < T_E$ the inhomogeneous magnetic field evolves according to $B_2(r,t) = -B_1(r, T_E-t)$, where $B_1(r,t)$ describes the evolution of the field from t=0 to $T_E/2$. A suitable choice of echo times and sequence repetition times in MRI can be used to thereby obtain images with tissue contrast.

With respect to the time for acquiring images in the method of the invention, an essential aspect is that the pulse sequences result in a unique MR phase evolution at each position in the ROI, which implies two critical consequences. One, the whole ROI can be sampled simultaneously, since the reconstruction techniques (for example, matrix inversion, ART, etc.) can screen the contribution of each individual voxel with respect to the recorded signal. This results in strong signals and high Signal-to-Noise ratios (SNR). Second, a single trajectory (for example, a Lissajous trajectory) in k-space is sufficient for object reconstruction, removing the need for a full sweep. Both factors mean that times for acquiring images in the sequences of the method of the invention are intrinsically short.

Preferred embodiments of the method of the invention:

The first embodiment is based on a circular rotating linear gradient in the xy-plane, superimposed on a static linear gradient along the z-axis. In the image in k-space, this corresponds to a helix with a fixed radius and cycle height (or "pitch"), from which a 3D reconstruction cannot be obtained by means of a simple TF. The graphs in Figure 4 are the result of a computer simulation of a sequence according to the method of the invention. The first graph (Figure 4a) shows the real and imaginary components of the signal emitted by a portion of a human brain measuring 21 mm$^3$ and recorded in the detector (the MR signal). Said Figure 4 further shows reconstruction by direct inversion of the encoding matrix, using $n_{vox}$ = 21$^3$ cubic voxels and time steps of 500 ns, over a total acquisition time of 10 ms. The amplitude of the oscillating and static gradients is $\approx$ -0.7 T/m, and the rotation frequency of the oscillating part is $\omega_R \approx 2\pi \cdot$ 173 Hz. The error in reconstruction is about 1.6%, defined as:

$$\epsilon = \sum_{i=1}^{n_{\text{vox}}} |b_{\text{o},i} - b_{\text{r},i}|$$

(Eq. 6)

where $b_{\text{o},i}$ is the brightness of i-th voxel of the original object, and $b_{r,i}$ is said brightness, but for the reconstructed object.

Figures 4b and 4c represent the comparison between the reconstructed object and the original object, respectively. Figure 4d represents the same comparison, with a selection of cross sections in directions x, y, z.

Figure 5 is the same simulation as the simulation shown in Figure 4, but with the only difference being that the radial component of the linear gradient oscillates at $\omega_R = 2\pi \cdot$10 kHz. The error for this case is $\approx$ 8.3%. Due to the averaging effect resulting from fast rotations for the same set of parameters, the resolution achieved and the general quality of the reconstruction worsen with increasing oscillation frequency.

Figures 6 and 7 are similar simulations for of rotation frequencies of 173 Hz and 100 kHz and for the same situation as above, but where the gradients are quadratic rather than in linear. Second-order terms have sizes of $\approx$ 16.3 and $\approx$ -4.7 T/m$^2$ in the axial and radial directions, respectively. Inhomogeneous high-order terms cause the evolution of the MR phase to differ on smaller length scales, which improves spatial resolution and facilitates reconstruction. Errors in this case do not depend on $\omega_R$ in the same way and amount to $\approx$ 2.1% at 173 Hz but are only 0.06% at 100 kHz.

Figures 8 and 9 show similar simulations for a sequence according to the method of the invention, in which the linear gradients oscillate over time in the three spatial dimensions, with a rotation in the xy-plane at $\approx$ 173 Hz, with a sinusoidal oscillation of 100 Hz in the z direction. The error upon performing analytical reconstruction by means of direct matrix inversion is about 3% for a 10 ms acquisition window (Figure 8), whereas at such short times, algebraic reconstruction techniques are not reconstructed with a high quality (about 25%), which requires data recorded over 50 ms to lower the error to $\approx$13% (Figure 9).

Therefore, it can be seen that the objects of the invention set forth above, which are apparent from the above description, are achieved in an efficient manner. It is likewise possible to also make modifications when carrying out the above method with respect to the preferred embodiments set forth without departing from the spirit and the scope of the invention, where it is understood that the subject matter contained in the above description and shown in the attached drawings is interpreted as being illustrative in a non-limiting manner.

It should also be understood that the following claims intend to cover all the generic and specific features of the invention described herein, as well as any variation of the scope of the invention which, due to reasons of language or terminology, could be inferred as pertaining to the same.

**Claims**

1. A method for acquiring images of an object by magnetic resonance through the use of time-varying inhomogeneous magnetic fields,
   **characterized in that** said method comprises performing the following steps:

   a) generating a plurality of time-varying, inhomogeneous, gradient-type magnetic fields on a region of interest in which the object is completely or partially contained, producing a spatial encoding of the magnetization of the nuclear spins of said object in the region of interest;
   b) applying a plurality of radiofrequency electromagnetic radiation pulse sequences on the object, generating magnetic resonance signals, wherein:

   - the spins of the object in the region of interest are resonantly excited with the radiofrequency electromagnetic radiation pulses;
- the inhomogeneous magnetic fields are pulsed for one or more signal acquisition intervals, such that the evolution of the magnetic resonance phase of the spins is unique for each point of said region of interest; and
- the projection of local gradient magnetic fields along each of the three orthogonal spatial axes in the laboratory frame of reference does not fade away for at least a fraction of the duration of the radiofrequency pulses in the region of interest;

c) detecting, demodulating, and storing the generated magnetic resonance signals, completing a first magnetic resonance scan of the object;
d) repeating steps a)-c) above, performing one or more improvement scans, providing separate information about the object in said scans;
e) reconstructing the spectra of the magnetic resonance signals emitted by the nuclei of the object and one or more images of said object from the information generated by means of steps a)-d) and from the temporal and spatial characteristics of the inhomogeneous magnetic fields generated in the region of interest for each scan.

2. The method according to the preceding claim, wherein in each of the improvement scans of step d):

- the pulse sequence of the inhomogeneous magnetic field gradients is carried out with modifications in the spatial distribution, the magnitude, or the temporal evolution of said magnetic fields, in relation to the first scan or to one another; and/or
- the analog and/or digital processing of magnetic resonance signals is performed by means of a reconstruction method differing from the reconstruction method of the first scan.

3. The method according to any of the preceding claims, wherein the generation of inhomogeneous magnetic fields comprises a linear or non-linear magnetic field gradient which rotates or oscillates about an axis in a plane, and a second static, linear or non-linear magnetic field gradient, applied along a normal axis to said plane.

4. The method according to any of claims 1-2, wherein the generation of inhomogeneous magnetic fields comprises a first linear or non-linear magnetic field gradient which rotates about an axis in a plane, and a second linear or non-linear magnetic field gradient which oscillates along the normal axis to said plane, and at a different angular frequency with respect to that of the first gradient.

5. The method according to any of claims 1-2, wherein the generation of inhomogeneous magnetic fields comprises a plurality of linear or non-linear magnetic field gradients, which are made to oscillate and/or rotate over time along the three orthogonal axes in space.

6. The method according to any of claims 3-5, wherein the angular frequency and/or the phase of the magnetic field gradients rotating and/or oscillating vary in each improvement scan in step d).

7. The method according to any of claims 2-5, wherein one or more of the inhomogeneous magnetic field gradients are zero in a value of space or of time, and wherein said gradients shift and/or evolve differently in each improvement scan in step d).

8. The method according to any of the preceding claims, wherein the magnetic resonance signals are demodulated with a different frequency in each improvement scan in step d).

9. The method according to any of the preceding claims, wherein the detection of step c) is performed by means of an array-type arrangement of receiving coils, and by means of applying parallel magnetic resonance image reconstruction techniques.

10. The method according to any of the preceding claims, wherein the reconstruction of the images of step e) is carried out by means of the inversion of an encoding matrix, and said matrix is multiplied by the vector of the recorded discrete time signal, or with its discrete Fourier transform.

11. The method of the preceding claims, wherein image reconstruction is carried out by means of an analytical method for the iterative resolution of a system of linear equations, which relates the recorded magnetic resonance signal with the spin density distribution of the object.

12. The method according to any of the preceding claims, wherein image reconstruction is performed by means of using Hankel transforms or by means of integrating Bessel functions, with or without the use of an encoding matrix.

13. The method according to any of the preceding claims, wherein the temporal evolution of the magnetic resonance phase of the spins of the object is inverted by means of the dynamic control of magnetic field gradients, generating one or more echoes in the detected magnetic resonance signal.

14. The method according to any of the preceding claims, wherein inhomogeneous field gradients vary only in two spatial dimensions, and the reconstructed image is a 2D image.

15. An apparatus for acquiring images of an object by magnetic resonance through the use of time-varying inhomogeneous magnetic fields, comprising:

- a magnet casing;
- a main magnet housed in the casing and suitable for generating a magnetic field on the object;
- a plurality of compensation coils;
- a plurality of gradient coils suitable for generating a plurality of inhomogeneous magnetic field gradients on a region of interest in which the object is completely or partially arranged;
- one or more radiofrequency coils suitable for generating radiofrequency electromagnetic radiation pulses on the object;
- one or more receiving coils;
- a control system for controlling the magnetic field generated by the main magnet, of the field generated by the gradient coils, and for controlling the pulses generated by the radiofrequency coils, configured for generating magnetic resonance signals in the object;
- a system for detecting, demodulating, and storing the generated magnetic resonance signals;

said apparatus being **characterized in that** the control system for controlling the magnetic field and the system for detecting, demodulating, and storing the generated magnetic resonance signals are configured, through hardware- and software-based processing means, for carrying out a method according to any of the preceding claims.

FIG. 1a

FIG. 1b

FIG. 1c

**FIG. 2**

**FIG. 3a**

**FIG. 3b**

**FIG. 3c**

**FIG. 4a**

**FIG. 4b**

## FIG. 4c

s(t) [a.u.]

error=8.30%

## FIG. 5a

## FIG. 5b

x=1                    y=1                    z=1

x=11                   y=11                   z=11

x=21                   y=21                   z=21

**FIG. 5c**

**FIG. 6a**

**FIG. 6b**

x=1  y=1  z=1

x=11  y=11  z=11

x=21  y=21  z=21

**FIG. 6c**

error=0.06%

**FIG. 7a**

**FIG. 7b**

x=1          y=1          z=1

x=11          y=11          z=11

x=21          y=21          z=21

**FIG. 7c**

error=3.04%

**FIG. 8a**

**FIG. 8b**

**FIG. 8c**

error=12.97%

## FIG. 9a

## FIG. 9b

x=1        y=1        z=1

x=11        y=11        z=11

x=21        y=21        z=21

## FIG. 9c

## INTERNATIONAL SEARCH REPORT

| International application No. |
|---|
| PCT/ES2020/070481 |

### A. CLASSIFICATION OF SUBJECT MATTER

*G01R33/38* (2006.01)
*G01R33/48* (2006.01)
According to International Patent Classification (IPC) or to both national classification and IPC

### B. FIELDS SEARCHED

Minimum documentation searched (classification system followed by classification symbols)
G01R

Documentation searched other than minimum documentation to the extent that such documents are included in the fields searched

Electronic data base consulted during the international search (name of data base and, where practicable, search terms used)

EPODOC, INVENES, internet

### C. DOCUMENTS CONSIDERED TO BE RELEVANT

| Category* | Citation of document, with indication, where appropriate, of the relevant passages | Relevant to claim No. |
|---|---|---|
| Y | US 5365172 A (HROVAT MIRKO I ET AL.) 15/11/1994, par. 2, col. 3; par. 3-5, col. 4; par. 1-4, col. 7; par. 2-3, 5, col. 8; par. 1-4, col. 9; fig. 1, 3, 13, 15; | 1-15 |
| Y | WO 2017210225 A1 (Q BIO INC) 07/12/2017, par. [0009-0010]; [0064]; [0109]; [0118]; [0236-0239]; [0277-0284]; fig. 12-13; | 1-15 |
| A | WIKIPEDIA. Physics of Magnetic Resonance Imaging. 31/12/2017 [on line][retrieved on 16/07/2020]. Retrieved from <URL: https://web.archive.org/web/20171231031446/ https://en.wikipedia.org/wiki/Physics_of_magnetic_resonance_imaging> par. 1-2; par. 1, sect. 2.1; par. 1, sect. 3; par. 1, sect. 3.2; fig. 1-2; | 1-15 |

☒ Further documents are listed in the continuation of Box C.       ☒ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance. | |
| "E" earlier document but published on or after the international filing date | |
| "L" document which may throw doubts on priority claim(s) or which is cited to establish the publication date of another citation or other special reason (as specified) | "X" document of particular relevance; the claimed invention cannot be considered novel or cannot be considered to involve an inventive step when the document is taken alone |
| "O" document referring to an oral disclosure use, exhibition, or other means. | "Y" document of particular relevance; the claimed invention cannot be considered to involve an inventive step when the document is combined with one or more other documents , such combination being obvious to a person skilled in the art |
| "P" document published prior to the international filing date but later than the priority date claimed | |
| | "&" document member of the same patent family |

| Date of the actual completion of the international search | Date of mailing of the international search report |
|---|---|
| 06/11/2020 | **(10/11/2020)** |

| Name and mailing address of the ISA/ | Authorized officer |
|---|---|
| OFICINA ESPAÑOLA DE PATENTES Y MARCAS Paseo de la Castellana, 75 - 28071 Madrid (España) Facsimile No.: 91 349 53 04 | A. Oropesa García |
| | Telephone No. 91 3496874 |

Form PCT/ISA/210 (second sheet) (January 2015)

## INTERNATIONAL SEARCH REPORT

| International application No. |
| --- |
| PCT/ES2020/070481 |

| C (continuation). | DOCUMENTS CONSIDERED TO BE RELEVANT | |
| --- | --- | --- |
| Category * | Citation of documents, with indication, where appropriate, of the relevant passages | Relevant to claim No. |
| A | J. A. FESSLER. Model-Based Image Reconstruction for MRI. A Review of the Use of Iterative Algorithms. IEEE Signal Processing Magazine, 31/07/2010, pag.. 81-89 [on line][retrieved on 06/11/2020]. Retrieved from <URL: https://ieeexplore.ieee.org/stamp/stamp.jsp?tp=&arnumber=5484183> par. 1, col. 2, pag. 81; par. 3-4, col. 2, pag. 82; par. 1, col. 1; par. 3-5, col. 2, pag. 83; par. 2-4, col. 1; col. 2, pag. 84. | 1-15 |
| A | WIKIPEDIA. Hankel Transform. 29/12/2016 [on line][retrieved on 16/07/2020]. Retrieved from <URL: https://web.archive.org/web/20161229081113/ https://en.wikipedia.org/wiki/Hankel_transform#Relation_to_other_function_transforms> párr. 1; párr. 1, aptdo. 4.1. | 12 |

Form PCT/ISA/210 (continuation of second sheet) (January 2015)

## INTERNATIONAL SEARCH REPORT

Information on patent family members

| International application No. |
| --- |
| PCT/ES2020/070481 |

| Patent document cited in the search report | Publication date | Patent family member(s) | Publication date |
| --- | --- | --- | --- |
| US5365172 A | 15.11.1994 | WO9403822 A1<br>AU4798093 A | 17.02.1994<br>03.03.1994 |
| XP011311323 A | 01.07.2010 | NONE | |
| WO2017210225 A1 | 07.12.2017 | CN110140042 A<br>JP2019520120 A<br>US2019154783 A1<br>KR20190013837 A<br>EP3465186 A1<br>EP3465186 A4<br>WO2017210226 A1<br>US2017285122 A1<br>US10359486 B2<br>US2017285123 A1<br>US10222441 B2<br>US2017007148 A1<br>US10194829 B2<br>WO2017007696 A1 | 16.08.2019<br>18.07.2019<br>23.05.2019<br>11.02.2019<br>10.04.2019<br>26.02.2020<br>07.12.2017<br>05.10.2017<br>23.07.2019<br>05.10.2017<br>05.03.2019<br>12.01.2017<br>05.02.2019<br>12.01.2017 |

Form PCT/ISA/210 (patent family annex) (January 2015)